# EUROPÄISCHE PATENTSCHRIFT

(11) **EP 0 716 227 B1**
(45) Veröffentlichungstag und Bekanntmachung des Hinweises auf die Patenterteilung: **23.06.1999**
(21) Anmeldenummer: 95115185.1
(22) Anmeldetag: 27.09.1995
(51) Int. Cl.: F02P 17/12

(54) **Vorrichtung zum Erfassen von Zündsignalen**
Device for ignition signal acquisition
Dispositif de saisie de signal d'allumage

(30) Priorität: 06.12.1994 DE 4443304
(43) Veröffentlichungstag der Anmeldung: 12.06.1996
(73) Patentinhaber: ROBERT BOSCH GMBH, 70442 Stuttgart (DE)
(72) Erfinder: Bumen, Werner, D-73230 Kirchheim (DE)

(56) Entgegenhaltungen:
- EP-A- 0 596 233
- WO-A-92/10674
- DE-U- 8 910 945
- US-A- 4 758 791

## Beschreibung

Die Erfindung betrifft eine Vorrichtung zum Erfassen von Signalen nach der Gattung des Hauptanspruchs.

Aus der DE-U 89 10 945.7 ist eine Vorrichtung zum Messen des Sekundärspannungsverlaufes der Zündspule eines Verbrennungsmotors bekannt. Die Zündanlage enthält mehrere Zündspulen, wobei an den Sekundärwicklungen der Zündspulen jeweils eine Zündkerze angeschlossen ist. Zur Diagnose dieser Zündanlage sind Sensoren für kapazitve Signalauskopplungen vorgesehen, die in teilweise schwer zugängliche Einsteckschlitze lose einschiebbar sind. Diese sind zwischen einem Zündspulengehäuse und einem Stecker, der Zu- und Ableitungen von einer Zündtransformations-Einheit zu den Wicklungen der Zündspule aufweist, ausgebildet. In diese Einstecköffnungen sind als Blechstreifen ausgebildete Sensoren für die kapazitive Signalauskopplungen einschiebbar. Die ausgekoppelten Signale gelangen in unterschiedliche Signalauswerteschaltungen.

Der Erfindung liegt die Aufgabe zugrunde, eine Vorrichtung für eine einfache, sichere und schnelle Adaption von Sensoren für kapazitive Signalauskopplungen an Zündanlagen anzugeben.

Diese Aufgabe wird durch die im Hauptanspruch angegebenen Merkmale gelöst.

### Vorteile der Erfindung

Die erfindungsgemäße Vorrichtung zum Erfassen von Signalen an einer Zündanlage, die mehr als eine Zündspule enthält, weist den Vorteil einer einfachen Adaption der Sensoren für kapazitive Signalauskopplungen auf. Der den Sensor aufnehemende Adapter und die Haltevorrichtung können bevorzugt als Schnellbesfestigungssystem ausgebildet sein. Dadurch kann zur Durchführung der Diagnose ein schnelle Montage und Demontage der Sensoren an dem Meßpunkt erfolgen. Die Haltevorrichtung und der Adapter können insbesondere in Baugröße und Bauform als normierte Komponenten ausgebildet sein, so daß eine einfache und schnelle Adaption immer gewährleistet ist.

Die erfindungsgemäße Adaption des Sensors an der Haltevorrichtung weist weiterhin den Vorteil auf, daß der Sensor in einer definierten Lage anordenbar ist. Dadurch kann eine exakte Messung durchgeführt werden. Die Haltevorrichtung kann in einem vorgegebenen Meßpunkt an der Zündspule angeordnet sein, so daß eine optimale kapazitive Signalauskopplung ermöglicht ist. Durch die sichere und exakte Aufnahme des Adapters mittels der Haltevorrichtung kann der Adapter ebenso exakt an dem vorgegebenen Meßpunkt zu der Zündspule bzw. zu der Sekundärspule über die Haltevorrichtung angeordnet werden.

Die Ausbildung des Adapters, der den Sensor zumindest teilweise umschließt, weist desweiteren den Vorteil auf, daß der Sensor selbst klein gehalten werden kann, da die Haltefunktionen von dem Adapter übernommen werden können. Darüberhinaus kann die Störsicherheit wesentlich erhöht werden und der Sensor ist vor unsachgemäßer Handhabung durch den Adapter geschützt.

Vorteilhafte Weiterbildungen und Verbesserungen der im Hauptanspruch angegebenen Vorrichtung ergeben sich aus den Unteransprüchen.

Eine vorteilhafte Weiterbildung sieht vor, daß der Adapter und die Haltevorrichtung als lösbare Rastverbindung ausgebildet ist. Dadurch kann sichergestellt sein, daß erst beim Einrasten der Rastverbindung der Adapter in seiner vorgesehenen Lage für die exakte Messung positioniert ist. Diese Anordnung ist besonders für störungssichere Messungen im Fahrbetrieb von Vorteil, wie sie beispielsweise für eine Eigendiagnose bzw. Fehleranalyse verwendet werden kann. Ein selbständiges Lösen des Adapters aus der Haltevorrichtung aufgrund von äußeren Einflüssen, wie beispielsweise Erschütterungen oder Schwingungen während des Fahrbetriebes, kann durch die Rastverbindung unterbunden werden. Die Rastverbindung kann in bekannter Weise aus einem Rastnocken oder einem gefederten Rastelement ausgebildet sein und an dem Adapter in eine dafür vorgesehenen Vertiefung oder an einer Körperkante ein- bzw.angreifen.

Eine besonders vorteilhafte Weiterbildung sieht vor, daß der Adapter aus Kunststoff ausgebildet ist. Die Einbettung des Sensors in Kunststoff ist wegen der Störsicherheit besonders von Vorteil und ermöglicht dadurch zuverlässige Meßergebnisse. Der Adapter mit Sensor für die kapazitive Signalauskopplung kann bevorzugt als fertig konfektioniertes Austauschteil vorgesehen bei dem die Verbindungsleitungen zweckmäßigerweise bis zum Adapter abgeschirmt sind. Der Adapter kann als einfaches Kunststoffspritzteil ausgebildet sein.

Eine besonders vorteilhafte Weiterbildung sieht vor, daß die Haltevorrichtung eine schwalbenschwanzförmige Führung aufweist. Dies ermöglicht ein einfaches Einschieben des Adapters in die Haltevorrichtung und eine genaue Positionierung des Adapters zu dem vorgegebenen Meßpunkt. Zudem kann es anwendungsspezifisch erforderlich sein, daß der Adapter mit einer bestimmten Seitenfläche an der Zündspule angeordnet sein soll. Dies kann ebenfalls durch die Schwalbenschwanzführung sichergestellt sein.

Alternativ zu dieser Ausführungsform kann die Haltevorrichtung vorteilhafterweise spannhülsenförmig ausgebildet sein. Dadurch kann ein im Querschnitt runder Adapter in die Spannhülse einsteckbar sein, der durch die Aufweitung der freien Enden der Spannhülse über eine Flächenpressung auf den Umfang des zylindrischen Abschnitts desAdapters in der Haltevorrichtung gehalten werden kann.

Die beiden beispielhaft aufgeführten Ausführungsformen weisen den Vorteil auf, daß selbst nach längerer Betriebsdauer des Fahrzeuges trotz auftretender Verschmutzung eine sichere und schnellere Adaption der Sensoren für die kapazitive Signalauskopplung ermöglicht sein kann, da der sich ggfs. in der Haltevorrichtung angelagerte Schmutz aus der Haltevorrichtung in Einschieberichtung herausgedrückt werden kann. Eine Beeinträchtigung der kapazitiven Signalauskopplung aufgrund der Verschmutzung, die zu einer Beschädigung des Sensors führen könnte, kann durch die Anordnung des Sensors in dem Adapter nicht auftreten, da dieser durch den Adapter geschützt ist. Es kann auch vorteilhafterweise vorgesehen sein, daß an der Haltevorrichtung eine Schutzkappe oder dergleichen angeordnet ist. Diese kann als einfaches Spritzteil ausgebildet sein und mittels einer Steck-oder Rastverbindung an der Haltevorrichtung angeordnet sein.

Eine vorteilhafte Ausgestaltung der Erfindung ist darin zu sehen, daß die Haltevorrichtung seitlich oder oben liegend an der Zündspule angeordnet ist. Die dadurch geschaffene gute Zugänglichkeit kann eine schnelle und einfache Handhabbarkeit der Sensoren für die Diagnose der Zündanlagen ermöglichen.

Eine vorteilhafte Weiterbildung sieht vor, daß die Haltevorrichtung einteilig mit einem Gehäuse der Zündspule ausgebildet ist. Dadurch kann die Herstellung einer Haltevorrichtung und eventuell dazugehörige Montageteile als auch das Anbringen der Haltevorrichtung an der Zündspule entfallen. Zudem kann eine kompaktere Bauweise der Zündanlage erzielt werden.

Eine besonders vorteilhafte Weiterbildung ist die Adaption von mehreren Sensoren an einer Haltevorrichtung. Dadurch kann eine Haltevorrichtung für mehrere bzw. für alle Zündspulen vorgesehen sein, die zumindest jeweils an dem vorgegebenen Meßpunkt einen Adapter aufnehmen und der Zündspule zuordnen kann.

Eine besonders vorteilhafte Ausgestaltung der Erfindung sieht vor, daß an der Zündanlage ein Trägergehäuse vorgesehen ist, das für jede Zündspule zumindest eine in einem vorgegebenen Meßpunkt angeordnete Haltevorrichtung aufweist, die an einer seitlichen oder oberen, gut zugänglichen Gehäusewand des Trägergehäuses angeordnet sein können. Dieses Trägergehäuse kann die Zündspulen zumindest teilweise umschließen. Die Zündspulen können dabei bevorzugt in dem Trägergehäuse motorspezifisch anordenbar und befestigbar sein. Durch die Ausbildung von nur einem Trägergehäuse kann eine vereinfachte und kostengünstige Anordnung zur Aufnahme der Adapter geschaffen werden. Das Trägergehäuse kann beispielsweise aus Kunststoff ausgebildet sein. Zudem können die von einer Zündtransistoren-Einheit zu den Wicklungen der Zündspule führenden Zu- und Ableitungen darin aufgenommen werden, so daß diese von dem Trägergehäuse geschützt werden können. Dadurch kann eine kompakte Anordnung der Zündspulen und deren Zu- und Ableitungen geschaffen werden, die die Motorraumoptik verbessern kann.

### Zeichnung

Ein Ausführungsbeispiel der Erfindung ist in der Zeichnung dargestellt und in der nachfolgenden Beschreibung näher erläutert. Es zeigen:
- Fig. 1: eine Skizze einer erfindungsgemäßen Vorrichtung zum Erfassen von Signalen an einer Zündanlage,
- Fig. 2: eine alternative Ausführungsform zu Fig. 1 und
- Fig. 3: ein Trägergehäuse zur Aufnahme von mehreren Sensoren für kapazitive Signalauskopplungen an einer Zündanlage.

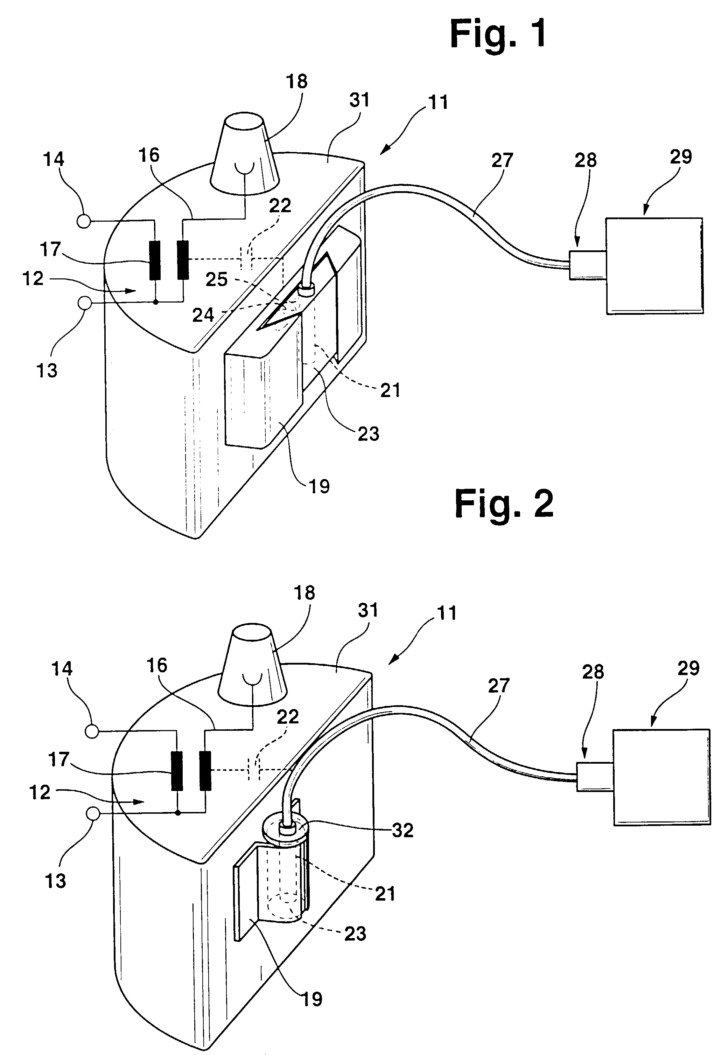

Fig. 1 zeigt eine Zündspule 11 einer Zündanlage, die aus wenigstens zwei Zündspulen besteht. In der Zündspule 11 ist ein Ersatzschaltbild 12 dargestellt. Dieses zeigt Primäranschlüsse 13, 14, die zu in Fig. 1 nicht dargestellten Zündungsschaltgeräten führen. Ein Sekundäranschluß 16 einer Sekundärwicklung 17 führt zu einem Hochspannungsanschluß 18.

An der Zündspule 11 ist eine Haltevorrichtung 19 vorgesehen, die einen Sensor 21 für kapazitive Signalauskopplungen aufnimmt. Die kapazitive Kopplung ist durch einen strichliniert dargestellten Kondensator 22 verdeutlicht, der als Bauteil nicht vorhanden ist. Der Sensor 21 ist in einem Adapter 23 angeordnet, der in der Haltevorrichtung 19 anbringbar ist. Der als Elektrode bzw. als Elektrodenhülse ausgebildete Sensor 21 ist in dem aus Kunststoff hergestellten Adapter 23 eingebettet und ermöglicht dadurch eine störungssichere Messung.

Die Haltevorrichtung 19 weist eine Schwalbenschwanzführung auf, in die der Adapter 23, der als An- bzw. Einsteckteil ausgebildet, anbringbar ist. In der Haltevorrichtung 19 ist der komplementär ausgebildete Adapter 23 einführbar, so daß der Adapter 23 in einer definierten Lage in der Haltevorrichtung 19 positionierbar ist. Die Haltevorrichtung 19 ist an einem vorgegebenen Meßpunkt zu der Zündspule 11 bzw. zu der Sekundärwicklung 17 angeordnet ist. Dadurch kann eine optimale Signalauskopplung erfolgen.

Die Haltevorrichtung 19 oder der Adapter weisen einen Anschlag (nicht dargestellt) auf, der den Adapter 23 in seiner Einschieberichtung begrenzt und in einer definierten Lage positioniert. In der Halterführung ist ein Rastnocken 24 vorgesehen, der in eine Vertiefung 26 des Adapters 23 eingreift und diesen in dem vorgegebenen Meßpunkt hält. Es können auch weitere bekannte Rast- bzw. Schnapphakenverbindungen oder dgl. vorgesehen sein, die den Adapter 23 in der Haltevorrichtung 19 gegen selbständiges Lösen sichern.

Die Haltevorrichtung19 kann zur Aufnahme des Adapters 23 ebenso weitere Nut- und Federverbindungen aufweisen, die eine genaue und sichere Aufnahme des Adapters 23 in der Haltevorrichtung 19 ermöglichen. Die Haltevorrichtung 19 kann über eine lösbare oder nicht lösbare Verbindung wie beispielsweise eine Steck-, Rast-, Klemm- Niet-, Klebe- oder Schraubverbindung mit der Zündspule 11 verbindbar sein. Alternativ dazu kann die Haltevorrichtung 19 als Teil der Zündspule 11 ausgebildet sein, so daß die Haltevorrichtung 19 bei der Ausbildung des Gehäuses 31 bzw. bei der Herstellung des Gehäuses 31 in der Gehäusewand integriert ist.

Der Sensor 21 ist mit einer Verbindungsleitung 27 über eine weitere Steckverbindung 28 mit einer Schaltungsanordnung 29 verbunden, die ein Teil einer Diagnoseschaltung darstellt.

In Fig. 2 ist eine alternative Ausführungsform einer Haltevorrichtung 19 mit einem Adapter 23 dargestellt. Diese Haltevorrichtung 19 ist spannhülsenförmig ausgebildet und in der dargestellten Position von dem Adapter 23 aufgeweitet. Die freien Enden der Hülse können daher den Adapter 23 festklemmen. Am oberen Ende des Adapters 23 ist eine Schulter 32 ausgebildet, die an dem oberen Rand der Haltevorrichtung 19 zum Anliegen kommt, sobald der Adapter 23 so weit in die Haltevorrichtung 19 eingeschoben ist, bis dieser in dem vorgegebenen Meßpunkt positioniert ist. Eine Rastverbindung für den zylindrischen Adapter 23 kann beispielsweise durch einen daran vorgesehenen, umlaufenden Wulst gegeben sein, der in eine Vertiefung der Haltevorrichtung 19 eingreift. Der Adapter 23 ist ebenfalls über die Verbindungsleitung 27 mittels einer Steckverbindung 28 mit der Schaltungsanordnung 29 verbindbar.

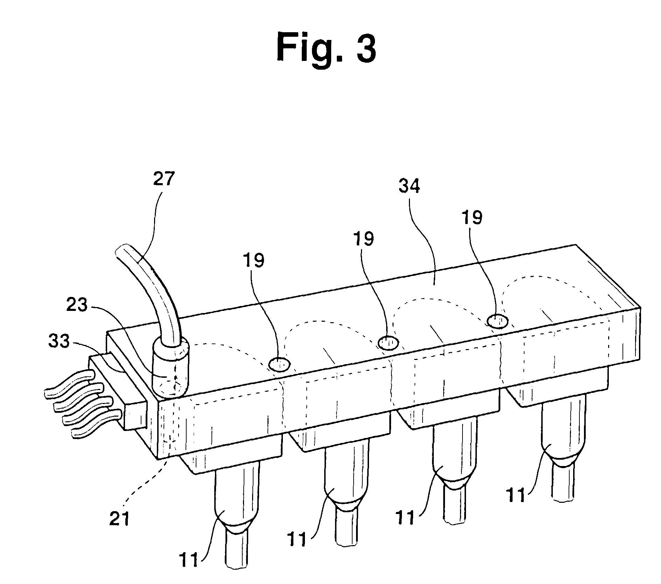

In Fig. 3 ist beispielhaft eine Zündanlage mit vier Zündspulen 11 dargestellt, die wiederum jeweils einer Zündkerze (nicht dargestellt) zugeordnet sind. Am oberen Ende der vier Zündspulen 11 ist ein Trägergehäuse 34 vorgesehen, das vier Haltevorrichtungen 19 auf der Oberseite des Trägergehäusese 34 aufweist, die jeweils an dem vorgegebenen Meßpunkt zu der jeweiligen Zündspule 11 angeordnet sind. Die Haltevorrichtung 19 ist als eine Durchgangsbohrung ausgebildet, die zusätzlich noch einen daran anschließenden Schaft zur sicheren Aufnahme aufweisen kann, in die der Adapter 23, wie in Fig. 3 dargestellt ist, einsteckbar ist. Der Adapter 23 ist somit an dem Trägergehäuse 34 derart angeordnet, daß der Sensor 21 vollständig in das Trägergehäuse 34 hineinragt und an dem vorgegebenen Meßpunkt positioniert ist.

Das Trägergehäuse 34 umgibt die Zündspulen 11 im wesentlichen vollständig. Die Zündspulen 11 sind in dem Trägergehäuse 34 motorspezifisch angeordnet und befestigt. Es kann ebenso vorgesehen sein, daß das Trägergehäuse 34 an den Zündspulen 11 befestigbar ist. Desweiteren kann vorgesehen sein, daß das Trägergehäuse 34 als ein Adapter ausgebildet ist, der für die Diagnose auf die Zündspulen 11 aufsetzbar bzw. an diesen anordenbar ist. Dadurch kann beispielsweise eine einfache und schnelle Handhabung für die Adaption der Sensoren 21 an den Zündspulen 11 zur Durchführung einer Diagnose gegeben sein.

An einer Seitenfläche des Trägergehäuses 34 ist eine Ausnehmung 33 für die Zu- und Ableitungen von einer Zündtransformations-Einheit zu den Wicklungen der Zündspulen 11 vorgesehen. Diese können ebenso in dem Trägergehäuse 34 angeordnet sein.

Alternativ zu dem Trägergehäuse 34 kann ebenso eine Trägerplatte bzw. Mehrfach-Haltevorrichtung vorgesehen sein, an die entsprechend der Anzahl der Zündspulen 11 Adapter 23 mit den Sensoren 21 anordenbar sind. Über Befestigungsmittel, wie beispielsweise Schraub-, Steck- oder Klemmverbindungen oder dergleichen, kann die Trägerplatte an den Zündspulen 11 angeordnet werden. Die Trägerplatte ist bevorzugt seitlich oder von oben auf die Zündspulen 11 befestigbar, so daß eine einfache Handhabbarkeit für das Anbringen der Adapter 23 gegeben sein kann. Das Trägergehäuse 34 bzw. die Trägerplatte und die Haltevorrichtung 19 sind bevorzugt aus Kunststoff ausgebildet.

Die Haltevorrichtung 19 des Trägergehäuses 34 kann für den Adapter 23, wie in Fig. 2 dargestellt ist, an einer Seitenfläche des Trägergehäuses 34 integriert sein, so daß der Adapter in seiner eingesetzten Position mit einer nach außen weisenden Seitenfläche bündig mit der Seitenfläche des Trägergehäuses 34 sein kann. In der Einsetzposition des Adapters 23 ist der Sensor 21 in einer optimalen Lage für eine kapazitive Signalauskopplung angeordnet.

Eine weitere vorteilhafte Ausgestaltung des Trägergehäuses zur Aufnahme der Zündspulen sieht vor, daß die Sensoren in dem Trägergehäuse fest angeordnet sein können. Die Sensoren können mit Steckverbindungen, die in der Trägergehäusewand angeordnet sind, verbunden sein. Daran sind Verbindungsleitungen anschließbar, die die Sensoren mit der Schaltungsanordnung des Diagnosegerätes verbinden können. Dadurch kann eine Anordnung der Sensoren zu den Zündspulen in einem sonst eher schwer zugänglichen Bereich vorgesehen sein und für den Benutzer des Diagnosegerätes dennoch eine leichte und direkte Zugänglichkeit durch die an der oberen oder seitlichen Gehäusewand angeordneten Steckverbindungen gegeben sein.

## Patentansprüche

1. Vorrichtung zum Erfassen von Signalen an einer Zündanlage, die mehr als eine Zündspule enthält, mit wenigstens einer kapazitiven Signalauskopplung, wobei wenigstens ein Sensor für die kapazitive Signalauskopplung in eine wenigstens an einer Zündspule ausgebildeten Aussparung an einem vorgegebenen Meßpunkt anordenbar ist; dadurch gekennzeichnet, daß die Aussparung als eine Haltevorrichtung (19) ausgebildet ist, die einen den Sensor (21) für die kapazitive Signalauskopplung (22) zumindest teilweise umschließenden Adapter (23) in einer definierten Lage aufnimmt.

2. Vorrichtung nach Anspruch 1, dadurch gekennzeichnet, daß die Haltevorrichtung (19) und der Adapter (23) eine lösbare Rastverbindung bilden.

3. Vorrichtung nach Anspruch 1 oder 2, dadurch gekennzeichnet, daß der Adapter (23) aus Kunststoff ausgebildet ist.

4. Vorrichtung nach einem der vorhergehenden Ansprüche, dadurch gekennzeichnet, daß die Haltevorrichtung (19) eine Schwalbenschwanzführung aufweist, in der ein komplementärer Adapter (23) anordenbar ist.

5. Vorrichtung nach einem der Ansprüche 1 bis 3, dadurch gekennzeichnet, daß die Haltevorrichtung (19) spannhülsenförmig ausgebildet ist, in die ein zylindrisch ausgebildeter Adapter (23) einsteckbar ist.

6. Vorrichtung nach einem der Ansprüche 1 bis 3, dadurch gekennzeichnet, daß die Haltevorrichtung (19) zur Aufnahme des Adapters (23) als Nut-und Federverbindung ausgebildet ist.

7. Vorrichtung nach einem der vorhergehenden Ansprüche, dadurch gekennzeichnet, daß die Haltevorrichtung (19) seitlich oder oben liegend an der Zündspule (11) angeordnet ist.

8. Vorrichtung nach einem der vorhergehenden Ansprüche, dadurch gekennzeichnet, daß die Haltevorrichtung (19) einteilig mit einem Gehäuse (31) der Zündspule (11) ausgebildet ist.

9. Vorrichtung nach einem der Ansprüche 1 bis 7, dadurch gekennzeichnet, daß an einer Haltevorrichtung (19) wenigstens zwei Adapter (23) anordenbar sind, wobei für jeweils eine Zündspule (11) zumindest ein Sensor (21) enthaltender Adapter (23) anbringbar ist.

10. Vorrichtung nach Anspruch 9, dadurch gekennzeichnet, daß die Haltevorrichtung (19) als Trägergehäuse (34) ausgebildet ist.

11. Vorrichtung nach einem der vorhergehenden Ansprüche, dadurch gekennzeichnet, daß die Haltevorrichtung (19) bzw. der Meßpunkt farblich gekennzeichnet ist.

## Claims

1. Device for acquiring signals in an ignition system which contains more than one ignition coil, having at least one capacitive signal extraction, it being possible to arrange at least one sensor for the capacitive signal extraction in a recess, formed at least on an ignition coil, at a predefined measuring point, characterized in that the recess is designed as a mounting device (19) which receives, in a defined position, an adapter (23) which at least partially encloses the sensor (21) for the capacitive signal extraction (22).

2. Device according to Claim 1, characterized in that the mounting device (19) and the adapter (23) form a releasable latching connection.

3. Device according to Claim 1 or 2, characterized in that the adapter (23) is formed from plastic.

4. Device according to one of the preceding claims, characterized in that the mounting device (19) has a dovetail guide in which a complementary adapter (23) can be arranged.

5. Device according to one of Claims 1 to 3, characterized in that the mounting device (19) is of clamping-sleeve-shaped design, and an adapter (23) of cylindrical design can be plugged in to it.

6. Device according to one of Claims 1 to 3, characterized in that the mounting device (19) is designed to receive the adapter (23) as a tongue and groove connection.

7. Device according to one of the preceding claims, characterized in that the mounting device (19) is arranged to the side of or above the ignition coil (11).

8. Device according to one of the preceding claims, characterized in that the mounting device (19) is formed in one piece with a housing (31) of the ignition coil (11).

9. Device according to one of Claims 1 to 7, characterized in that at least two adapters (23) can be arranged on one mounting device (19), it being possible to provide at least one adapter (23) containing a sensor (21) for, in each case, one ignition coil (11).

10. Device according to Claim 9, characterized in that the mounting device (19) is designed as a carrier housing (34).

11. Device according to one of the preceding claims, characterized in that the mounting device (19) and/or the measuring point are colour coded.

## Revendications

1. Dispositif de saisie de signaux d'une installation d'allumage comportant plus d'une bobine d'allumage, avec au moins un découplage capacitif des signaux,
au moins un capteur pour le découplage capacitif des signaux étant prévu dans au moins une cavité réalisée au niveau de la bobine d'allumage en un point de mesure prédéterminé,
caractérisé en ce que
la cavité est en forme de dispositif de fixation (19) qui reçoit dans une position définie, un adaptateur (23) entourant au moins partiellement le capteur (21) de découplage capacitif (22) des signaux.

2. Dispositif de saisie selon la revendication 1,
caractérisé en ce que
le dispositif de fixation (19) et l'adaptateur (23) forment une liaison encliquetée, amovible.

3. Dispositif de saisie selon la revendication 1 ou 2,
caractérisé en ce que
l'adaptateur (23) est en matière plastique.

4. Dispositif de saisie selon l'une quelconque des revendications précédentes,
caractérisé en ce que
le dispositif de fixation (19) comporte un moyen de guidage en queue d'aronde recevant un adaptateur (23) ayant une forme complémentaire.

5. Dispositif de saisie selon l'une des revendications 1 à 3,
caractérisé en ce que
le dispositif de fixation (19) est en forme de manchon de serrage dans lequel on engage un adaptateur (23) de forme cylindrique.

6. Dispositif de saisie selon l'une quelconque des revendications 1 à 3,
caractérisé en ce que
le dispositif de fixation (19) est réalisé sous la forme d'une liaison à rainure et languette pour recevoir l'adaptateur (23).

7. Dispositif de saisie selon l'une quelconque des revendications précédentes,
caractérisé en ce que
le dispositif de fixation (19) est prévu sur le côté ou sur le dessus, en position couchée par rapport à la bobine d'allumage (11).

8. Dispositif de saisie selon l'une quelconque des revendications précédentes,
caractérisé en ce que
le dispositif de fixation (19) est réalisé en une seule pièce avec le boîtier (31) de la bobine d'allumage (11).

9. Dispositif de saisie selon l'une des revendications 1 à 7,
caractérisé en ce que
le dispositif de fixation (19) comporte au moins deux adaptateurs (23) et, pour chaque bobine d'allumage (11), on a au moins un adaptateur (23) comportant un capteur (21).

10. Dispositif de saisie selon la revendication 9,
caractérisé en ce que
le dispositif de fixation (19) est en forme de boîtier de support (34).

11. Dispositif de saisie selon l'une quelconque des revendications précédentes,
caractérisé en ce que
le dispositif de fixation (19) ou le point de mesure sont repérés par une couleur.
